Europäisches Patentamt

European Patent Office

Office européen des brevets

(11) Veröffentlichungsnummer: **0 178 639**
**A2**

# (12) EUROPÄISCHE PATENTANMELDUNG

(21) Anmeldenummer: 85113088.0

(22) Anmeldetag: 15.10.85

(51) Int. Cl.⁴: **H01L 31/06** , H01L 29/167

(30) Priorität: 19.10.84 DE 3438436

(43) Veröffentlichungstag der Anmeldung:
23.04.86 Patentblatt 86/17

(84) Benannte Vertragsstaaten:
DE FR GB IT

(71) Anmelder: **Siemens Aktiengesellschaft**
**Berlin und München Wittelsbacherplatz 2**
**D-8000 München 2(DE)**

(72) Erfinder: **Krühler, Wolfgang, Dr.**
**Ludwig-Thoma-Strasse 80**
**D-8025 Unterhaching(DE)**

(54) **Solarzelle mit graduellem Energiebandabstand mit einem aus amorphen Silizium bestehenden Halbleiterkörper sowie Verfahren zu ihrer Herstellung.**

(57) Bei einer aus amorphem hydrogenisiertem Silizium bestehenden Solarzelle der Schichtenfolge pin (1, 2, 3) besteht die i-Schicht (3) aus einer Materialkombination mit unterschiedlichen Bandabständen, die sowohl eine Aufweitung als auch eine Verengung der Energiebandlücke ($E_g$) im amorphen Silizium bewirkt. Vorzugsweise entsteht die Materialkombination durch Einbau von Kohlenstoff oder Stickstoff und/oder durch Einbau von Germanium oder Zinn in die i-Schicht (3). Die Solarzelle ist durch HF-Glimmentladungsabscheidung in relativ einfacher Weise herstellbar und zeichnet sich dennoch durch eine maximale Lichtabsorption aus.

FIG 2

Solarzelle mit graduellem Energiebandabstand mit einem aus amorphem Silizium bestehenden Halbleiterkörper sowie Verfahren zu ihrer Herstellung.

Die Erfindung betrifft eine Solarzelle mit graduellem Energiebandabstand mit einem aus amorphem hydrogenisiertem Silizium (a-Si:H) bestehenden Halbleiterkörper, der zwischen einer p-Zone und einer n-Zone eine intrinsic(i)-Schicht enthält sowie ein Verfahren zur ihrer Herstellung.

Solarzellen aus amorphem hydrogenisiertem Silizium (a-Si:H) erreichen heute Wirkungsgrade bis zu 10 %. Dabei ist der erzeugte Photostrom von etwa 18 bis 20 mA/cm$^2$ relativ gering im Vergleich zur monokristallinen Silizium-Solarzelle (30 bis 35 mA/cm$^2$).

Unter den Abscheidebedingungen guter amorpher Silizium-Solarzellen mit pin-Struktur durch zum Beispiel HF-Glimmentladung liegt der Bandabstand des undotierten (i)-Materials bei etwa 1,7 bis 1,8 eV. Somit ist eine bestimmte Lichtabsorption und damit ein fester Photostrom vorgegeben.

Aufgabe der Erfindung ist es, eine amorphe Silizium-Solarzelle in Dünnschichtbauweise mit pin-Übergang anzugeben, die sich in technologisch relativ wenig aufwendiger Weise herstellen läßt und dennoch einen hohen Photostrom und damit eine hohe Lichtabsorption aufweist.

Das Problem der Photostromerhöhung wurde teilweise bisher nur durch Verwendung von Fensterschichten - das sind p-dotierte Schichten mit Kohlenstoffeinbau - oder durch geeignete Texturierung von Substraten gelöst. So ist aus dem Buch "Amorphe und polykristalline Halbleiter" von W. Heywang, Springer-Verlag 1984, Seite 63, bekannt, durch relativ einfache Kohlenstoffzumischung in der p-Zone das amorphe Silizium in SiC überzuführen und damit die Bandlücke aufzuweiten.

Aus einem Aufsatz von M. C. Cretella und I. A. Gregory aus dem J. Electrochem. Soc. Solid-State Science and Technology, Dec. 1982, Seiten 2850 bis 2855, ist aber auch bekannt, durch Einbringen von Germanium in hydrogenisiertem amorphem Silizium die Energiebandlücke im amorphen Silizium zu verengen und dadurch die Zelleneigenschaften in bezug auf die Rotempfindlichkeit zu verbessern.

Dieses Ergebnis wird in einem Aufsatz von Nakamura et. al. im Journal of Non-Crystalline Solids 59/60 (1983), Seiten 1111 bis 1114 (North-Holland Publishing Comp.) dazu benutzt, Tandem-Solarzellen (das sind mehrere, durch fortgesetzten Niederschlag übereinander hergestellte pin-Zellen in Serienschaltung) auf der Basis von amorphem Silizium mit drei Zellen aufzubauen, bei denen die unterste, undotierte (i)-Schicht aus der Materialkombination a-Si$_{0,55}$Ge$_{0,45}$:H besteht, während die oberste und mittlere i-Schicht a-Si:H enthält. Durch geschickte Wahl der Schichtdicken der nacheinander folgenden i-Zonen und der Dotierungen der dazwischenliegenden n- und p-Schichten, sowie durch eine stark reflektierende Oberfläche des Substrats wird hier ein Wirkungsgrad von 8,6 % bei einer guten Spektralempfindlichkeit erreicht. Aus diesem Bericht ist auch bekannt, daß durch Einbau von Stickstoff die hydrogenisierte amorphe Si-Schicht (a-SiN:H) die Energiebandlücke E$_g$ von a-SiH aufgeweitet werden kann.

Diese Erkenntnisse macht sich die Erfindung zur Lösung ihrer Aufgabe der vereinfachten Herstellung einer Solarzelle mit hohem Photostrom und optimaler Lichtabsorption zunutze; sie ist dadurch gekennzeichnet, daß die i-Schicht aus Materialkombinationen mit unterschiedlichen Bandabständen besteht, die sowohl eine Aufweitung als auch eine Verengung der Energiebandlücke im hydrogenisierten amorphen Silizium bewirken. Dabei liegt es im Rahmen der Erfindung, daß die Materialkombination der i-Schicht durch Einbau von Kohlenstoff (C) oder Stickstoff (N) und/oder durch Einbau von Germanium (Ge) oder Zinn (Sn) in die amorphe Siliziumschicht gebildet wird.

Während bei der bekannten Tandemtyp-Solarzelle Si/Si/SiGe nach Nakamura dafür drei übereinander aufgebrachte (stacked) Solarzellen erforderlich sind, und ein Photostrom von 6,41 mA/cm$^2$ bei einer Leerlaufspannung V$_{oc}$ = 2,2 V, ein Füllfaktor von 60 % und ein Wirkungsgrad von 8,6 % erhalten wird, wird bei der erfindungsgemäßen Anordnung mit nur einer Solarzelle vom pin-Typ mit einer aus bis je zur halben Schichtdicke bestehenden Materialkombination von a-Si$_{1-x}$C$_x$:H mit sinkender C-Konzentration und a-Si$_{1-x}$Ge$_x$:H mit steigender Ge-Konzentration der i-Schicht bei optimaler Lichtausbeute ein Photostrom von 25 mA/cm$^2$ bei einer Leerlaufspannung V$_{oc} \approx$ 0,9 V, ein Füllfaktor FF von 75 % sowie ein Wirkungsgrad von 16 % erreicht.

Dies beruht darauf, daß durch die Aufweitung der Energiebandlücke E$_g$ durch den Kohlenstoffeinbau eine bessere Ausbeute des blauen Lichtanteils im Sonnenspektrum bewirkt wird, während die Verengung von E$_g$ durch den Germaniumeinbau in der i-Schicht zu einer besseren Rotausbeute führt.

Zur Verbesserung der Alterungsbeständigkeit kann bei der erfindungsgemäßen Solarzelle in die i-Schicht zusätzlich noch ein in Richtung i-n-Übergang linear abnehmendes Bordotierungsprofil eingebaut werden.

Weitere Ausgestaltungen der Erfindung, insbesondere Verfahren zu ihrer Herstellung, ergeben sich aus den Unteransprüchen.

Die Erfindung wird im folgenden anhand der Figuren 1 bis 3 noch näher erläutert. Dabei zeigt

die Figur 1 den zur Herstellung der in Figur 2 schematisch dargestellten Anordnung der Zonen der Solarzelle vorgegebenen Konzentrationsverlauf bzw. die Zusammensetzung der Materialkombinationen in der i-Schicht,

die Figur 2 die pin-Solarzelle mit dem graduellen Energiebandabstand E$_g$ in der i-Schicht und

die Figur 3 die spektralen Empfindlichkeitskurven einer normalen pin-Zelle (Kurve a) und einer pin-Zelle mit gradueller Energiebandlücke (Kurve b).

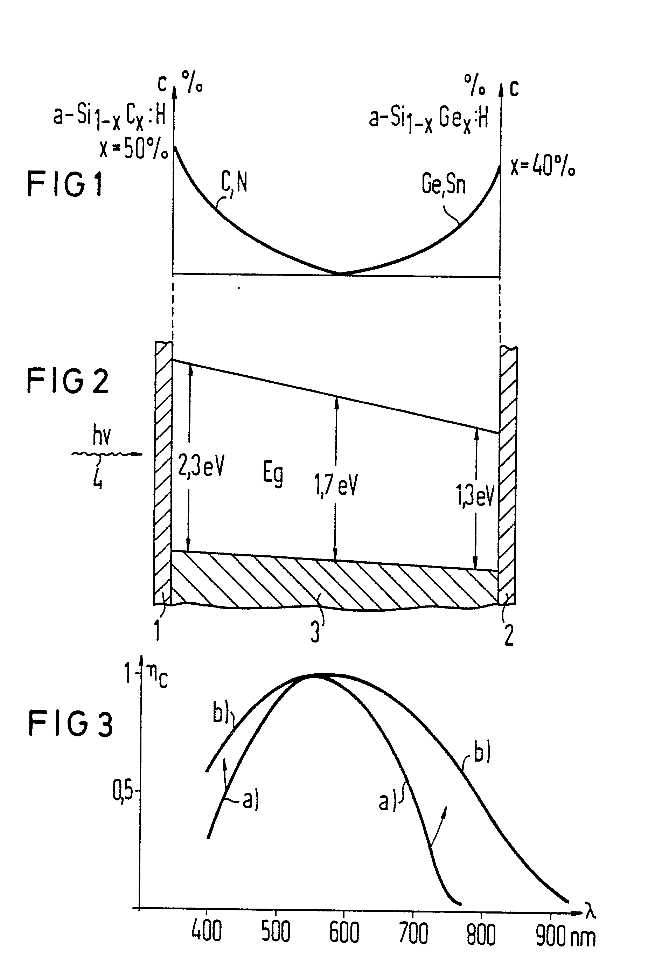

Figuren 1 und 2: Die geeigneten Materialkombinationen von zum Beispiel a-SiC:H und a-SiGe:H mit den unterschiedlichen Bandabständen werden durch eine kontinuierliche Änderung der Gasmischungen, die die zur Bildung der i-Schicht vorgesehenen gasförmigen Wasserstoffverbindungen wie Silan (SiH$_4$), German (GeH$_4$) und Methan (CH$_4$) enthalten, während der Abscheidung in einem HF-Glimmentladungsreaktor erhalten. Die Parameter zur Abscheidung, wie Temperatur, Druck und Abscheiderate, sind bekannt. Wie aus der Figur 1 zu entnehmen ist, wird zunächst während der Abscheidung von amorphem Silizium aus Silan nach der Erzeugung der p-dotierten Schicht 1 dem Silan 50 % Methan (CH$_4$) zugesetzt und diese Konzentrationbis zur halben Schichtdicke der i-Schicht (3), das heißt bei einer Schichtdicke von 1 µm bis zu 0,5 µm, stetig bis auf Null abgesenkt. Dadurch wird die Energiebandlücke im a-Si:H von etwa 2,3 ev auf 1,7 eV graduell eingestellt (siehe Figur 2).

Dann erfolgt eine kontinuierliche Zumischung von German (GeH₄) zum Silan, bis mit einer Konzentration von 40 % German im Silan die Schichtdicke der i-Schicht 3 von 1 µm erreicht ist. Auf diese Weise nimmt die Verengung von $E_g$ von 1,7 eV auf etwa 1,3 eV ab (siehe Figur 2). Der Pfeil 4 zeigt die Richtung des Lichteinfalls (hν) an.

Figur 3: Als Abszisse ist der Sammel- Wirkungsgrad $\eta_c$ und als Ordinate die Wellenlänge λ des Lichts in nm aufgetragen. Die Kurve a zeigt die spektrale Empfindlichkeit einer normalen pin-Zelle aus amorphem Silizium (mit i = aSi:H) und die Kurve b die spektrale Empfindlichkeit einer erfindungsgemäßen Solarzelle, wie sie nach dem bei Figur 1 und 2 beschriebenen Verfahren hergestellt worden ist. Ein Vergleich der beiden Kurven zeigt deutlich die Verbreiterung der Empfindlichkeitskurve bei der Zelle nach der Lehre der Erfindung.

**Ansprüche**

1. Solarzelle mit graduellem Energiebandabstand mit einem aus amorphem, hydrogenisierten Silizium (a-Si:H) bestehenden Halbleiterkörper, der zwischen einer p-Zone (1) und einer n-Zone (2) eine intrinsic (i)-Schicht (3) enthält, **dadurch gekennzeichnet,** daß die i-Schicht (3) aus Materialkombinationen mit unterschiedlichen Bandabständen besteht, die sowohl eine Aufweitung als auch eine Verengung der Energiebandlücke im hydrogenisierten, amorphen Silizium bewirken.

2. Solarzelle nach Anspruch 1, **dadurch gekennzeichnet,** daß die Materialkombination durch Einbau von Kohlenstoff (C) oder Stickstoff (N) und/oder durch Einbau von Germanium (Ge) oder Zinn (Sn) in die amorphe Siliziumschicht (3) entsteht.

3. Solarzelle nach Anspruch 1 und/oder 2, dadurch gekennzeichnet, daß die i-Schicht (3) bis zur halben Schichtdicke aus a-Si$_{1-x}$C$_x$:H mit bis auf Null sinkendem C-Gehalt besteht, wobei x = 50 % C am pi-Übergang und die zweite Hälfte der i-Schicht (3) aus a-Si$_{1-x}$Ge$_x$:H mit von Null ansteigendem Ge-Gehalt besteht, wobei x = 40 % Ge am i-n-Übergang ist.

4. Solarzelle nach Anspruch 1 bis 3, **dadurch gekennzeichnet,** daß in der i-Schicht (3) zusätzlich ein in Richtung i-n-Übergang (2) linear abnehmendes Bordotierungsprofil enthalten ist.

5. Verfahren zum Herstellen einer Solarzelle nach mindestens einem der Ansprüche 1 bis 4, **dadurch gekennzeichnet,** daß der Einbau von Kohlenstoff oder Stickstoff, Germanium oder Zinn über ihre gasförmigen Verbindungen, vorzugsweise Wasserstoffverbindungen, erfolgt, die dem zur Bildung der i-Schicht (3) vorgesehenen gasförmigen Silan (SiH₄) während der HF-Glimmentladungsabscheidung in entsprechender Konzentration c zugesetzt werden.

6. Verfahren nach Anspruch 5, **dadurch gekennzeichnet,** daß die Konzentration c der zugesetzten Stoffe während der Abscheidung variiert wird.

7. Verfahren nach mindestens einem der Ansprüche 5 und 6, **dadurch gekennzeichnet,** daß bei der Abscheidung der i-Schicht (3) nach erfolgter Abscheidung der p-Schicht (1) zunächst Methan (CH₄) dem Silan (SiH₄) zugesetzt wird, dessen Konzentration c bis zur halben Schichtdicke der i-Schicht (3) von ca. x = 50 %, bezogen auf die Verbindung a-Si$_{1-x}$C$_x$H bis auf 0 abgesenkt wird und dann kontinuierlich bis zur vollen Schichtdicke der i-Schicht (3) German (GeH₄) dem Silangas bis zu einer Konzentration c von x = ca. 40 % bezogen auf die Verbindung a-Si$_{1-x}$Ge$_x$H zugegeben wird.

8. Verfahren nach mindestens einem der Ansprüche 5 bis 7, **dadurch gekennzeichnet,** daß die Dicke der i-Schicht (3) auf 0,4 bis 1 µm eingestellt wird.

9. Verfahren nach mindestens einem der Ansprüche 5 bis 8, **dadurch gekennzeichnet,** daß zur Verbesserung der Alterungsbeständigkeit bei der Abscheidung der i-Schicht (3) durch Zumischen von Boran (B₂H₄) zusätzlich ein in Richtung i-n-Übergang (2) linear abnehmendes Bordotierungsprofil erzeugt wird.

0 178 639

FIG 1

a-Si$_{1-x}$C$_x$:H
x = 50%

C, N

a-Si$_{1-x}$Ge$_x$:H

x = 40%

Ge, Sn

FIG 2

hv
4

2,3 eV

Eg

1,7 eV

1,3 eV

1          3          2

FIG 3

$\eta_C$

b)
a)
b)
a)

400   500   600   700   800   900 nm